# EUROPÄISCHE PATENTSCHRIFT

(11) **EP 0 615 337 B1**
(45) Veröffentlichungstag und Bekanntmachung des Hinweises auf die Patenterteilung: **23.04.1997**
(21) Anmeldenummer: 94101172.8
(22) Anmeldetag: 27.01.1994
(51) Int. Cl.: H03G 3/32

(54) **Verfahren zur Lautsprechereinstellung**
Method for setting the level of a loudspeaker
Procédé pour le réglage d'un haut-parleur

(30) Priorität: 10.03.1993 DE 4307446
(43) Veröffentlichungstag der Anmeldung: 14.09.1994
(73) Patentinhaber: Bayerische Motoren Werke Aktiengesellschaft, 80788 München (DE)
(72) Erfinder: Kirk, Edgar, D-81737 München (DE)

(56) Entgegenhaltungen:
- EP-A- 0 578 008
- DE-A- 2 836 371
- DE-A- 3 830 423
- US-A- 5 034 984
- US-A- 5 204 971

## Beschreibung

Die Erfindung bezieht sich auf ein Verfahren nach dem einleitenden Teil des Patentanspruchs 1.

Ziel bekannter Verfahren dieser Art (DE-OS 3830423) ist es, den Lautstärke-Istpegel höher als den Pegel der Fahrzeuginnenraum-Geräusche zu legen. Hierzu wird in aller Regel mit Hilfe eines Mikrofons der Geräuschpegel bestimmt und abhängig davon der Lautstärke-Istpegel geregelt. Da sich der Geräuschpegel insbesondere abhängig von der Fahrzeuggeschwindigkeit beständig ändert, ergibt sich bei Änderungen der Fahrzeuggeschwindigkeit eine deutlich wahrnehmbare Änderung des Istpegels. Dieser unangenehme Effekt ist bedingt durch die notwendigerweise stets vorhandene Reaktionszeit einer Regeleinrichtung.

In der eingangs genannten Druckschrift sind Maßnahmen beschrieben, die bei einem Anstieg des Innengeräusches bzw. bei einem Abfall eine unterschiedliche Reaktion der Lautstärke-Regeleinrichtung bewirken, um derartige Effekte zu vermeiden. Dies bedingt jedoch einen erheblichen Aufwand. Hinzu kommt als grundsätzliches Problem, daß mit Hilfe eines Mikrofons das Innengeräusch nicht frequenzselektiv, sondern allenfalls über einen bestehenden Frequenzbereich gemittelt aufgenommen wird. Besondere Frequenzen, die in aller Regel fahrzeugtypspezifisch vorhanden sind, lassen sich dabei nur unzureichend berücksichtigen.

In EP-A-0 578 008 wird ein Verfahren und eine Schaltung zur Durchführung des Verfahrens zur Geräuschverdeckung in Kraftfahrzeugen bei der Wiedergabe von elektrischen Nutzsignalen über von Equalizern angesteuerten Lautsprechern beschrieben. Die Equalizer sind in verschiedenen Frequenzbändern getrennt einstellbar, wobei die Einstellung entsprechend dem Verhältnis des Nutzsignales in den einzelnen Frequenzbänder zu vorher in einem Eichvorgang festgelegten frequenzbandspezifischen Bezugsgrößen erfolgt und die frequenzbandspezifische Bezugsgröße aus der momentanen Geschwindigkeit des Fahrzeuges hergeleitet wird. EP-A-0 578 008 stellt einen Stand der Technik gemäß Artikel 54(3) für die benannten Vertragsstaaten DE, FR, GB, IT, dar.

Der Erfindung liegt die Aufgabe zugrunde, ein Verfahren der eingangs genannten Art zu schaffen, bei dem mit geringem Aufwand eine möglichst wirklichkeitsgetreue Einstellung der Lautstärke auch bei einer fahrzeuggeschwindigkeitsabhängigen Änderung des Innen-Geräuschpegels erreicht wird.

Die Erfindung löst diese Aufgabe durch die Merkmale des Patentanspruch 1.

Im Gegensatz zu dem bekannten Verfahren handelt es sich bei der Erfindung um eine Steuerung. Ein irgendwie gearteter Lautstärkeaufnehmer für die Innengeräusche entfällt. Ebenfalls entfällt jede Rückwirkung bzw. ein zeitlicher Verzug zwischen beispielsweise einer Änderung des Sollpegels und der Anpassung des Istpegels gegebenenfalls in Verbindung mit einer Änderung der Fahrzeuggeschwindigkeit und damit einer Änderung des Innen-Geräuschpegels.

Grundsätzlich werden bei der Erfindung nur die Frequenzen bzw. Frequenzanteile mit ihrem Istpegel verändert, die mit ihrem Sollpegel unter dem Geräuschpegel liegen. Die anderen Frequenzanteile bleiben unverändert bzw. werden entsprechend beispielsweise den Erfordernissen, die durch die Raumakustik des Fahrzeuginnenraums bedingt sind, verändert.

Die Erfindung ist grundsätzlich realisierbar mit Hilfe nur einer Bezugskurve, die beipielsweise dem Innen-Geräuschpegel für eine mittlere Fahrzeuggeschwindigkeit entspricht. Eine deutliche Verbesserung der Anpassung des Istpegels läßt sich erzielen, wenn die Bezugskurve fahrzeuggeschwindigkeitsabhängig veränderlich ist. Diese Bezugskurven werden beispielsweise vor der Inbetriebnahme des Kraftfahrzeugs in einem entsprechenden Steuergerät festgelegt und entsprechen den Innengeräuschen, die für das betreffende Kraftfahrzeug bzw. den jeweiligen Fahrzeugtyp in vorausgehenden Versuchen ermittelt wurden.

Die Erfindung ist anhand der Zeichnung näher erläutert. Es zeigt
- Fig. 1: ein Diagramm zur Erläuterung der Erfindung, bei der nur eine einzige Bezugskurve verwendet wird und
- Fig. 2: ein Diagramm, bei dem die Bezugskurve fahrzeuggeschwindigkeitsabhängig veränderlich ist.

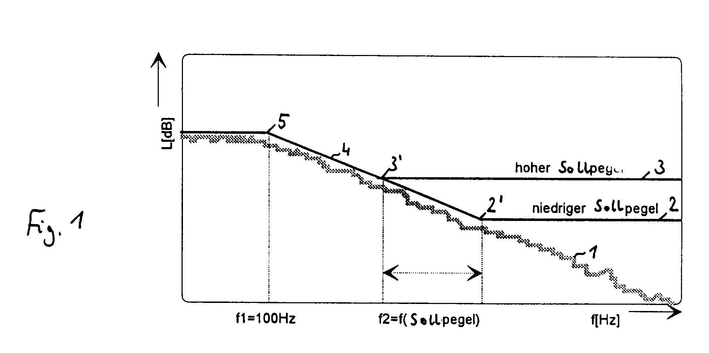

Das in Figur 1 dargestellte Diagramm zeigt den Innengeräuschpegel eines Kraftfahrzeugs bei einer vorgegebenen Geschwindigkeit. Die Darstellung ist logarithmisch und erfolgt in Abhängigkeit von der Frequenz. Die Bezugskurve 1 dient als Referenz bei der Einstellung eines definierten Lautstärke-Sollpegels mit Hilfe eines nicht dargestellten Lautstärkestellers. Es sind zwei Fälle angenommen. Der erste, durch die Gerade 2 repräsentierte Fall bezieht sich auf einen niedrigen Sollpegel, der zweite Fall, mit dem Bezugszeichen 3 versehen, auf einen hohen Sollpegel.

Der Einfachheit halber ist der eingestellte Wert des Sollpegels für den höheren Frequenzbereich als Gerade angenommen. Verzerrungseffekte, die im Hinblick auf die gewünschte Raumakustik diesem Sollpegel überlagert sind, sind aus Gründen der Einfachheit weggelassen.

Erfindungsgemäß wird eine Veränderung des Sollpegels zu dem tatsächlich vorliegenden Istpegel nur in dem Umfang vorgenommen, wie dies aufgrund der Bezugskurve 1 notwendig ist. Das bedeutet, daß bei hohen Frequenzen zunächst keinerlei Veränderung des Sollpegels erfolgt. Erst in dem Bereich, in dem sich der Sollpegel der Bezugskurve annähert bzw. erreicht - für die Kurve 2 ist dieser Punkt mit 2', für die Kurve 3 mit 3' bezeichnet - wird eine Anhebung des Pegels zum Istpegel vorgenommen. Die anhebung erfolgt für niedrige Frequenzen f₁ (bis ca. 100 Hz) um einen konstanten Betrag und für höhere Frequenzen, schematisch durch den geneigten Abschnitt 4 vom Punkt 5 bis hin zum korrespondierenden Punkt 2' oder 3' dargestellt, mit abnehmenden Wert bis hin zu der Frequenz f₂, bei der der Istpegel gleich dem Sollpegel ist.

Es ist ohne weiteres erkennbar, daß für einen niedrigen Sollpegel bis hin zu einer höheren Frequenz eine Anhebung für die niedrigeren Frequenzen vorgenommen wird. Allgemein läßt sich ferner sagen, daß zur Kompensation der Fahr- bzw. Umweltgeräuscheinflüsse bei gleichbleibender Geschwindigkeit, jedoch wechselndem Sollpegel, es notwendig ist, die tiefen Frequenzanteile bei niedrigen Sollpegeln stärker anzuheben.

Im Gegensatz zu einer Lautstärkeregelung bzw. -steuerung, bei der der Anstieg des Fahrgeräusches mit der Geschwindigkeit durch eine geschwindigkeitsabhängige Pegelanhebung für alle Frequenzen kompensiert wird, ergibt sich bei der Erfindung ein subjektiv gleichbleibender Lautstärkeeindruck. Im Gegensatz zu der breitbandigen Anhebung der Lautstärke lassen sich hier die Spektralverteilung des Störsignals und die frequenzabhängigen Verdeckungseffekte berücksichtigen.

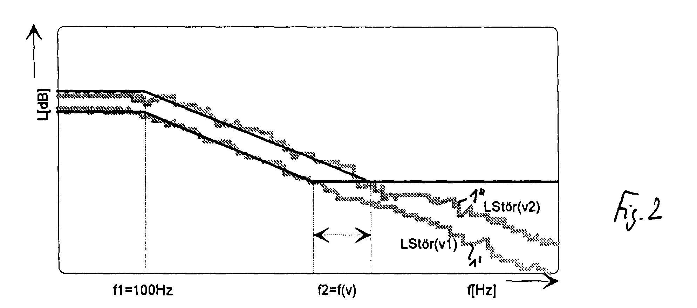

Während im Figur 1 nur eine über sämtliche Fahrzeuggeschwindigkeiten gemittelte Bezugskurve 1 zugrunde gelegt wurde, ergibt sich bei Figur 2 eine fahrzeuggeschwindigkeitsabhängige Variation der Bezugskurve. Dies ist schematisch für eine Bezugskurve 1' für eine niedrige Fahrzeuggeschwindigkeit und eine Bezugskurve 1'' für eine höhere Fahrzeuggeschwindigkeit dargestellt. Wie in Figur 1 im Prinzip dargestellt, erfolgt hier eine Anhebung des Sollpegels dann, wenn diese im Bereich der Bezugskurve verläuft. Für einen vorgegebenen Sollpegel erfolgt bei hohen Fahrzeuggeschwindigkeiten bereits bei höheren Frequenzen eine Pegelanhebung in etwa parallel zur Bezugskurve. Da auch im vorliegenden Fall unter einer Frequenz von 100 Hz die Bezugskurve einen konstanten, lediglich fahrzeuggeschwindigkeitsabhängigen Wert besitzt, erfolgt in diesem Frequenzbereich keine Veränderung des Istpegels.

Auch hier handelt es sich um eine reine Steuerung, bei der auf ein Mikrofon oder dgl. zur Aufnahme des Umgebungs-bzw. Fahrgeräusches verzichtet ist und lediglich fahrzeuggeschwindigkeitsabhängige Bezugskurven berücksichtigt sind.

## Patentansprüche

1. Verfahren zur Lautstärkeeinstellung bei einem Audiogerät von Kraftfahrzeugen, bei dem durch einen Lautstärkesteller ein Lautstärke-Sollpegel (2, 3) vorgegeben wird, der Sollpegel mit einer festgelegten frequenzabhängigen Fahrzeuginnengeräusch-Bezugskurve für einen Geräusch-Bezugspegel (1, 1', 1") verglichen wird, daß die Frequenzen, deren Sollpegel über dem Bezugspegel liegen, unverändert bleiben und die Frequenzen, deren Sollpegel unter dem Bezugspegel liegen, auf einen Istpegel (4, 5) angehoben werden, der auf oder über dem Bezugspegel liegt wobei die Bezugskurve vor der Inbetriebnahme ermittelt und festgelegt wird.

2. Verfahren nach Anspruch 1, dadurch gekennzeichnet, daß die Bezugskurve fahrzeuggeschwindigkeitsabhängig veränderlich ist.

## Claims

1. A method for the setting of volume levels for an audio unit of motor vehicles, wherein a volume target level (2, 3) is specified by a volume setting device, the target level is compared with a pre-established frequency-dependentvehicle interior noise reference curve for a noise reference level (1, 1', 1"), the frequencies, which have a target level above the reference level, remain unchanged and those frequencies which have a target level below the reference level are elevated to an actual level (4, 5) which lies at or above the reference level, wherein the reference curve is established and set before installation.

2. A method according to claim 1, characterised in that the reference curve can be changed in a manner which is vehicle-speed dependent.

## Revendications

1. Procédé de réglage d'intensité sonore d'un appareil audio équipant un véhicule automobile, et qui, par un moyen de réglage de l'intensité sonore prédétermine un niveau de consigne (2, 3) de l'intensité sonore, le niveau de consigne étant comparé à une courbe de références de bruits à l'intérieur du véhicule, courbe fixée en fonction de la fréquence pour un niveau de références de bruits (1, 1', 1"), les fréquences dont le niveau de consigne est supérieur au niveau de références restant inchangées alors que les fréquences dont le niveau de consigne est inférieur au niveau de référence sont relevées à un niveau réel (4, 5) situé sur ou au-dessus du niveau de référence, la courbe de références étant déterminée et fixée avant la mise en route.

2. Procédé selon la revendication 1,
caractérisé en ce que
la courbe de références est variable en fonction de la vitesse de déplacement du véhicule.
